# EUROPEAN PATENT SPECIFICATION

(11) **EP 1 397 975 B1**
(45) Date of publication and mention of the grant of the patent: **23.11.2005**
(21) Application number: 02388062.8
(22) Date of filing: 12.09.2002
(51) Int. Cl.: A45F 5/00

(54) **An electronic device provided with a concealed strap holder**
Elektronisches Gerät mit versteckter Riemenbefestigung
Appareil électronique comportant une fixation de sangle cachée

(43) Date of publication of application: 17.03.2004
(73) Proprietor: Sony Ericsson Mobile Communications AB, 221 88 Lund (SE)
(72) Inventor: Carlsson, Marcus, 112 26 Stockholm (SE)
(74) Representative: Sundien, Thomas

(56) References cited:
- US-A- 5 737 412
- US-B1- 6 188 362
- US-B1- 6 352 186

## Description

The invention relates to a portable electronic device comprising a housing and at least one detachable cover element and being provided with strap-attaching means provided on the housing for attaching a carrying strap to the electronic device.

### Related prior art

It is known to provide small-sized portable electronic devices, such as wireless telephones, mobile telephones, cameras, video cameras, etc., with means for attaching a carrying strap in order to enable the user to carry the electronic device by wrapping the carrying strap around e.g. his/her wrist. Such carrying straps are conventionally attached to the electronic device by the strap or a part thereof being pulled through an eyelet provided at the outer wall of the housing of the electronic device. The eyelet can be arranged to be protruding from the housing of the electronic device, or it can be configured as a through-going bore from one side of the housing to an adjacent side of the housing. ExampJes of such strap-attaching arrangements are shown in e.g. JP-2001160851 and JP-2000341382.

Another strap-attaching arrangement is shown in US-A-5 737 412 that discloses a portable telephone provided with a detachable carrying strap. In this device the carrying strap is attached to a hook provided at the upper end of an exchangeable battery pack. A latch mechanism provided on the housing of the portable telephone is arranged for engaging a part of the hook and thereby locking the battery pack to the portable telephone.

### Object of the invention

In the prior art portable electronic devices described above it is optional for the user to attach a carrying strap to the electronic device. If the user chooses to attach a carrying strap, it is pulled through the strap-attaching eyelet or hooked onto the hook provided on the battery pack. However, if the user chooses not to attach a carrying strap, the attaching means for the carrying strap, i.e. the eyelet on the housing or the hook on the battery pack, is clearly visible and disturbs negatively the overall visual appearance of the electronic device. It is therefore an object of the invention to provide an electronic device as mentioned in the opening paragraph in which the attaching means for attaching a carrying strap does not considerably influence the appearance of the electronic device if a carrying strap is not attached thereto.

### Summary of the invention

The object of the invention is achieved by configuring the portable electronic device in such manner that the attaching means is concealed by the detachable cover element, and that an opening giving access to a carrying strap from outside of the electronic device to the attaching means is provided.

Thereby is achieved that the strap-attaching means does not disturb the overall visual appearance of the portable electronic device when no strap is attached thereto, since only a small opening between the housing of the electronic device and the detachable cover element is visible.

In a preferred embodiment the strap-attaching means comprises an eyelet provided in a part of the housing. Provision of an eyelet for securing a carrying strap is generally well-known and ensures easy and reliable mounting of the carrying strap.

The eyelet may be provided in an inwardly protruding tongue provided in the housing, or it may be provided at an inwardly facing part of a wall of the housing. In either case the eyelet will be concealed by the detachable cover element so that the visual appearance of the electronic device is not disturbed even if no carrying strap is mounted.

As an alternative to providing an eyelet the strap-attaching means may comprise a hook provided inwardly in the housing. Mounting of a carrying strap is facilitated by this embodiment since a portion of the carrying strap can simply be wrapped around the hook.

Preferably, a recess is provided at an edge of the detachable cover element, which recess in combination with an edge of the housing form the opening for the carrying strap. Thereby the opening is only created when the detachable cover element is mounted on the housing.

In a preferred embodiment the detachable cover element is a battery cover, and the electronic device is a mobile radio station, such as a mobile telephone.

It shall be emphasised that the term "comprise/comprising" when used in this specification is taken to specify the presence of stated features, integers, steps or components but does not preclude the presence or addition of one or more other features, integers, steps components or groups thereof.

### Description of the drawings

The invention will be described in detail in the following with reference to the drawings in which
Fig. 1 shows a portion of a portable electronic device provided with a carrying strap according to a first embodiment of the invention;
Fig. 2 shows the same portion of a portable electronic device as Fig. 1, but without a carrying strap;
Fig. 3a-3b show a first embodiment of a strap-attaching means in the form of an eyelet provided in an inwardly protruding tongue in the housing of the electronic device;
Fig. 4a-4b show a second embodiment of a strap-attaching means in the form of an eyelet provided in the inwardly facing part of the wall of the housing of the electronic device; and
Fig. 5a-5b show a third embodiment of a strap-attaching means in the form of a hook provided inwardly in the housing of the electronic device.

### Detailed description of an embodiment of the invention

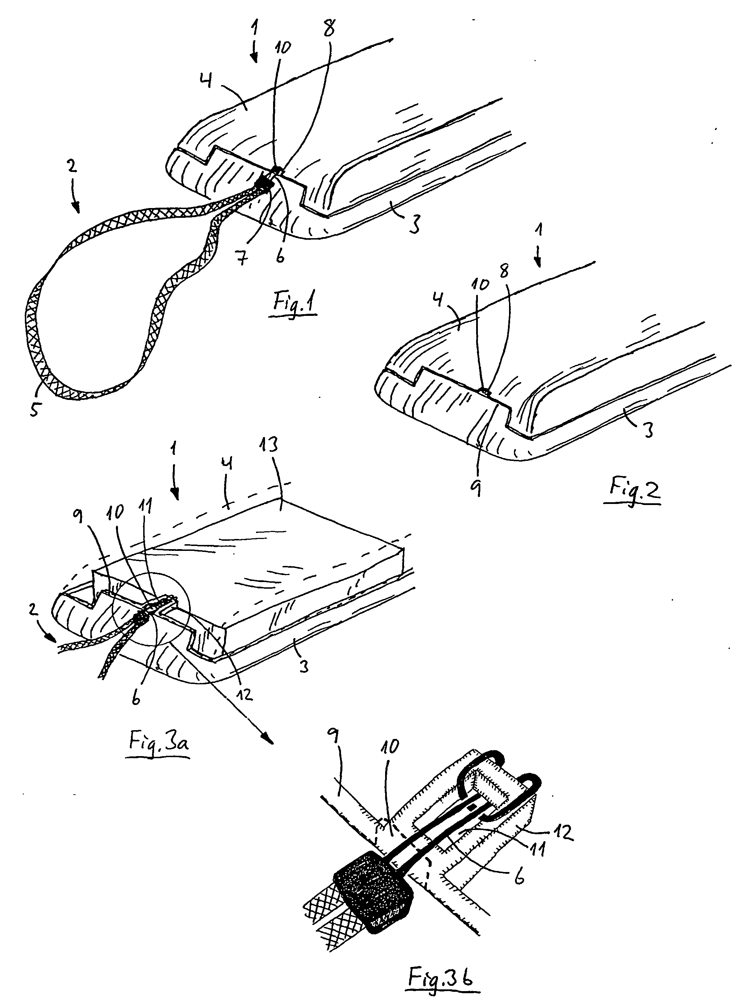

Fig. 1 shows a portion of a portable electronic device 1, which may be a mobile telephone, provided with a carrying strap 2 according to a first embodiment of the invention. The electronic device 1 comprises a housing 3, which may be a frame or a front cover of a mobile telephone, and a detachable cover element 4 that is releasably connected to the housing 3 by any known manner.

In the shown embodiment the carrying strap 2 comprises a band-like portion 5 and a string-loop portion 6 that are interconnected by a connector element 7. The band-like portion 5 is intended for being wrapped around the wrist of a user, and the string-loop portion 6 is intended for being attached to the housing of the electronic device 1 in a manner that will be described below with reference to Figs 3a-5b. The carrying strap 2 may of course be configured differently than shown in Fig. 1, e.g. as a simple looped string or band.

The carrying strap 2 is connected to the housing 3 of the electronic device 1 by means of strap-attaching means located within the electronic device 1, which, in accordance with the invention, is concealed by the detachable cover element 4. A recess 8 is provided at the edge of the detachable cover element 4, which recess together with an abutting edge 9 of the housing 3 forms a small opening 10 for the string-loop portion 6 of the carrying strap 2.

If the carrying strap 2 is shaped as e.g. a looped band or string only, the recess 8 and thereby the opening 10 must of course be dimensioned accordingly.

Fig. 2 shows the same portion of the portable electronic device1 as Fig. 1, but without a carrying strap 2. In Fig. 2 it is clearly illustrated that only a small opening 10 is provided between the recess 8 at the edge of the detachable cover element 4 and the abutting edge 9 of the housing 3, which opening does not considerably disturb the visual appearance of the electronic device 1 even when no carrying strap 2 is attached thereto.

Figs 3a and 3b show a first embodiment of the strap-attaching means in the form of an eyelet 11 provided in an inwardly protruding tongue 12 in the housing 3 of the electronic device 1. The tongue 12 protrudes inwardly from the edge 9 of the housing 3, and is fully concealed by the detachable cover element 4 shown in broken lines.

In the embodiment shown in Figs 3a and 3b the detachable cover element 4 is a battery cover covering an exchangeable battery 13 mounted in the electronic device 1. This configuration of a portable electronic device 1 is generally known in the art of mobile telephones, but the invention is just as applicable in other types of portable electronic devices provided with a detachable cover element.

To connect the carrying strap 2 to the eyelet 11 the detachable cover element 4 is initially removed from the housing 3 of the electronic device 1. Then the string-loop portion 6 is drawn through the eyelet 11 and the remaining part of the carrying strap 2 is drawn through the string-loop portion 6 on the opposite side of the tongue 12 to form a knot as best seen in Fig. 3b. The detachable cover element 4 is then re-mounted on the housing 3 of the electronic device 1 whereby it conceals the inwardly protruding tongue 12 with the eyelet 11. Only a small opening 10 for the string-loop portion 6 of the carrying strap 2 is then visible as described above with reference to Figs 1 and 2. During re-mounting of the detachable cover element 4 it must be ensured that the string-loop portion 6 of the carrying strap 2 extends correctly through the opening 10.

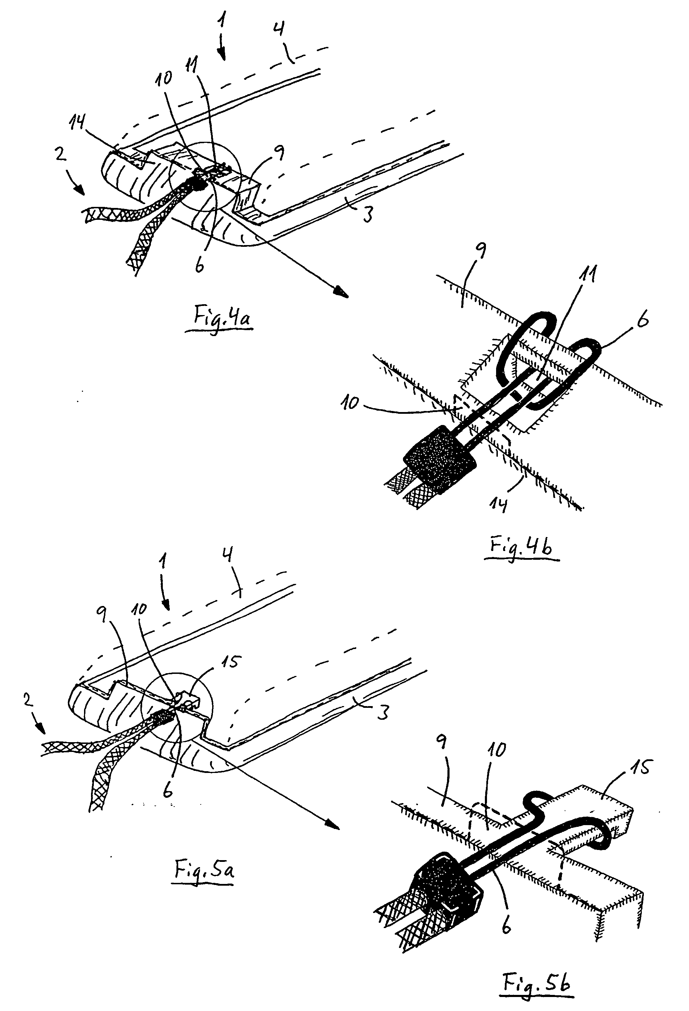

Figs 4a and 4b show a second embodiment of the strap-attaching means in the form of an eyelet 11 provided in the inwardly facing part of the wall 14 of the housing 3 of the electronic device 1. It is to be noted that the same reference numerals as used in Figs 1, 2, 3a and 3b are used for like parts with the same function even though small differences between the shown parts will appear. For example, the housing is denoted with the reference numeral 3 in Fig. 1, 2, 3a and 3b, but also in Fig. 4a despite small differences in the configuration of the housings. The same principle applies to Figs 5a and 5b described below.

The wall 14 shown in Figs 4a and 4b is relatively thick allowing the eyelet 11 to be shaped as a through-going bore extending from the upper edge 9 of the wall 14 to the inner surface (not shown) of the wall 14. Again, the attaching means comprising the eyelet 11 will be fully concealed when the detachable cover element 4 is mounted on the electronic device 1 as illustrated with broken lines.

To connect the carrying strap 2 to the eyelet 11, the detachable cover element 4 is initially removed from the housing 3 of the electronic device 1. Then the string-loop portion 6 is drawn through the eyelet 11 and the remaining part of the carrying strap 2 is drawn through the string-loop portion 6 on the opposite side of the tongue 12 to form a knot as best seen in Fig. 4b. The detachable cover element 4 is then re-mounted on the housing 3 of the electronic device 1 whereby it conceals the upper edge 9 of the wall 14. Only a small opening 10 for the string-loop portion 6 of the carrying strap 2 is then visible as described above with reference to Figs 1 and 2.

Figs 5a and 5b show a third embodiment of the strap-attaching means in the form of a hook 15 provided inwardly in the housing 3 of the electronic device 1. The hook 15 protrudes inwardly from the edge 9 of the housing 3, and is fully concealed by the detachable cover element 4 shown in broken lines.

To connect the carrying strap 2 to the hook 15, the detachable cover element 4 is initially removed from the housing 3 of the electronic device 1, and the string-loop portion 6 is manoeuvred around the hook 15 as shown most clearly in Fig. 5b. The detachable cover element 4 is then re-mounted on the housing 3 of the electronic device 1 whereby it conceals the inwardly protruding hook 15. Only the small opening 10 for the string-loop portion 6 of the carrying strap 2 is then visible as described above with reference to Figs 1 and 2.

With the embodiments described above a carrying strap 2 can easily be attached to the portable electronic device 1 if the user so desires. If the user chooses not to attach a carrying strap 2, the configuration of the elements in the portable electronic device 1 according to the invention entails that only a small opening 10 is visible. This small opening 10 does not disturb the overall visual appearance of the electronic device 1 as it is the case with the prior art strap-attaching means.

In the shown embodiments the opening 10 for the carrying strap 2 is created by co-operation of a recess 8 provided in the edge of the detachable cover element 4 and an abutting edge 9 of the housing 3. The recess may, of course, be provided in the housing, while the detachable cover element is provided with a straight edge, or both the housing and the detachable cover element could be provided with smaller recesses that together form the opening for the carrying strap.

Alternatively, the opening could be a through-going bore provided in the housing or in the detachable cover element, whereby the carrying strap must be introduced into the opening from the outside of the housing or the detachable cover element to be attached to the strap-attaching means located within the housing. Mounting of the carrying strap is thereby made more difficult than in the above-described embodiments, but it would be possible to locate the opening at a more suitable location.

The portable electronic device has been described as a mobile telephone. However, the configuration of the portable electronic device according to the invention is applicable to other types of portable electronic devices as well, such as cameras, video cameras, wireless telephones and other small size electronic devices to be carried by the user.

The configuration of the strap-attaching means can of course be different from the eyelet and hook shown in Figs 3a-5b. For instance, the strap-attaching means may comprise a clamping device located on the housing underneath the detachable cover element or the carrying strap may be secured to the housing by means of a screw.

Also, the carrying strap can be configured differently from the configuration shown in Figs 1-5b.

## Claims

1. A portable electronic device (1) comprising a housing (3) and being provided with strap-attaching means provided on the housing (3) for attaching a carrying strap (2) to the electronic device (1), the portable electronic device (1) further comprising an opening (10) giving access to a carrying strap (2) from outside of the electronic device (1) to the attaching means, **characterised in that** the strap-attaching means is concealed by a detachable cover element (4).

2. A portable electronic device according to claim 1, **characterised in that** the strap-attaching means comprises an eyelet (11) provided in a part of the housing (3).

3. A portable electronic device according to claim 2, **characterised in that** the eyelet (11) is provided in an inwardly protruding tongue (12) provided in the housing (3).

4. A portable electronic device according to claim 2, **characterised in that** the eyelet (11) is provided at an inwardly facing part of a wall (14) of the housing (3).

5. A portable electronic device according to claim 1, **characterised in that that** the strap-attaching means comprises a hook (15) provided inwardly in the housing (3).

6. A portable electronic device according to any one of claims 1-5, **characterised in that** a recess (8) is provided at an edge of the detachable cover element (4), said recess (8) in combination with an edge (9) of the housing (3) forming the opening (10) for a carrying strap (2).

7. A portable electronic device according to any one of claims 1-6, **characterised in that** the detachable cover element (4) is a battery cover.

8. A portable electronic device according to any one of claims 1-7, **characterised in that** the electronic device (1) is a mobile radio station, such as a mobile telephone.

## Patentansprüche

1. Tragbares elektronisches Gerät (1), umfassend ein Gehäuse (3) und versehen mit einer Riemenbefestigungsvorrichtung, die an dem Gehäuse (3) vorgesehen ist, um einen Trageriemen (2) am elektronischen Gerät (1) zu befestigen, wobei das tragbare elektronische Gerät (1) weiter eine Öffnung (10) umfasst, die einem Trageriemen (2) von außerhalb des elektronischen Geräts (1) Zugang zu der Befestigungsvorrichtung gewährt, **dadurch gekennzeichnet, dass** die Riemenbefestigungsvorrichtung von einem abnehmbaren Abdeckelement (4) verborgen ist.

2. Tragbares elektronisches Gerät nach Anspruch 1, **dadurch gekennzeichnet, dass** die Riemenbefestigungsvorrichtung eine Öse (11) umfasst, die auf einem Teil des Gehäuses (3) vorgesehen ist.

3. Tragbares elektronisches Gerät nach Anspruch 2, **dadurch gekennzeichnet, dass** die Öse (11) auf einer in dem Gehäuse (3) vorgesehenen, nach innen vorstehenden Zunge (12) vorgesehen ist.

4. Tragbares elektronisches Gerät nach Anspruch 2, **dadurch gekennzeichnet, dass** die Öse (11) auf einem nach innen gewandten Teil einer Wand (14) des Gehäuses (3) vorgesehen ist.

5. Tragbares elektronisches Gerät nach Anspruch 1, **dadurch gekennzeichnet, dass** die Riemenbefestigungsvorrichtung einen nach innen im Gehäuse (3) vorgesehenen Haken (15) umfasst.

6. Tragbares elektronisches Gerät nach einem der Ansprüche 1-5, **dadurch gekennzeichnet, dass** eine Vertiefung (8) an einer Kante des abnehmbaren Abdeckelements (4) vorgesehen ist, wobei die Vertiefung (8) in Kombination mit einer Kante (9) des Gehäuses (3) die Öffnung (10) für einen Trageriemen (2) bildet.

7. Tragbares elektronisches Gerät nach einem der Ansprüche 1-6, **dadurch gekennzeichnet, dass** das abnehmbare Abdeckelement (4) eine Batterieabdeckung ist.

8. Tragbares elektronisches Gerät nach einem der Ansprüche 1-7, **dadurch gekennzeichnet, dass** das elektronische Gerät (1) ein Mobilfunkendgerät, wie zum Beispiel ein Mobiltelefon ist.

## Revendications

1. Dispositif électronique portable (1) comprenant un boîtier (3) et étant doté d'un moyen d'attache de sangle prévu sur le boîtier (3) pour attacher une sangle de transport (2) au dispositif électronique (1), le dispositif électronique portable (1) comprenant de plus une ouverture (10) donnant accès à une sangle de transport (2) au moyen d'attache à partir de l'extérieur du dispositif électronique (1), **caractérisé en ce que** le moyen d'attache de sangle est caché par un élément de couvercle détachable (4).

2. Dispositif électronique portable selon la revendication 1, **caractérisé en ce que** le moyen d'attache de sangle comprend un oeillet (11) prévu dans une partie du boîtier (3).

3. Dispositif électronique portable selon la revendication 2, **caractérisé en ce que** l'oeillet (11) est prévu dans une languette saillante vers l'intérieur (12) prévue dans le boîtier (3).

4. Dispositif électronique portable selon la revendication 2, **caractérisé en ce que** l'oeillet (11) est prévu dans une partie orientée vers l'intérieur d'une paroi (14) du boîtier (3).

5. Dispositif électronique portable selon la revendication 1, **caractérisé en ce que** le moyen d'attache de sangle comprend un crochet (15) prévu vers l'intérieur dans le boîtier (3).

6. Dispositif électronique portable selon l'une quelconque des revendications 1 à 5, **caractérisé en ce qu'**une encoche (8) est prévue sur un bord de l'élément de couvercle détachable (4), ladite encoche (8) en combinaison avec un bord (9) du boîtier (3) formant l'ouverture (10). pour une sangle de transport (2).

7. Dispositif électronique portable selon l'une quelconque des revendications 1, à 6, **caractérisé en ce que** l'élément de couvercle détachable (4) est un couvercle de batterie.

8. Dispositif électronique portable selon l'une quelconque des revendications 1 à 7, **caractérisé en ce que** le dispositif électronique (1) est une station radio mobile, comme un téléphone mobile.
